# EUROPEAN PATENT APPLICATION

(11) **EP 3 570 318 A1**
(43) Date of publication of application: **20.11.2019**
(21) Application number: 18172390.9
(22) Date of filing: 15.05.2018
(51) Int. Cl.: H01L 21/60

(54) **METHOD FOR BONDING AN ELECTRICALLY CONDUCTIVE ELEMENT TO A BONDING PARTNER**

(71) Applicant: Infineon Technologies AG, 85579 Neubiberg (DE)
(72) Inventor: Eacock, Florian, 33102 Paderborn (DE); Strotmann, Guido, 59609 Anröchte (DE); Takkac, Alparslan, 59872 Meschede (DE)
(74) Representative: Westphal, Mussgnug & Partner Patentanwälte mbB

(57) **Abstract**

The invention relates to a method that includes bonding an electrically conductive element (1) to a bonding surface (2t) of a bonding partner (2) by: increasing a temperature of a bonding section (Is) of the electrically conductive element (1) from an initial temperature (T0) to an increased temperature (T1) by passing an electric heating current (I_{H}) through the bonding section (Is); pressing the bonding section (Is) with a pressing force (F) against the bonding surface (2t) using a sonotrode (3) and introducing an ultrasonic vibration into the bonding section (Is) via the sonotrode (3) such that the increased temperature (T1) of the bonding section (Is), the ultrasonic signal in the bonding section (Is) and the pressing force (F) are simultaneously present and cause the formation of a tight and direct bond between the bonding section (Is) and the bonding surface (2t).

## Description

### TECHNICAL FIELD

The instant disclosure relates to bonding techniques.

### BACKGROUND

Bonding techniques are widely used in various fields of electronics. For example, in many conventional applications aluminum wires are used to electrically contact electronic components like, e.g., semiconductor chips, circuit boards or the like. Typically, one or more aluminum wires are attached to a metallization of the electronic component using wire bonding. However, aluminum wires exhibit a limited ampacity and may cause a significant ohmic power loss. In view of permanently increasing power densities of modern electronic components, a high ampacity and a low ohmic power loss of a bonding wire is desirable. This could, in principle, be addressed by increasing the diameter of the bonding wire and/or by using a bonding wire having a resistivity lower than aluminum. With respect to materials having a low resistivity, promising candidates would be gold, silver and copper. Because of its high price, gold and silver are, at least for mass products, out of question. Therefore, copper or copper-based materials would be the materials of choice.

However, increasing the diameter of the bonding wire and/or moving from aluminum to copper or copper-based materials results in a more rigid bonding wire which in turn requires a higher pressing force during the wire bonding process and, therefore, involves the risk of cracks that may occur in the electronic component to which the rigid wire is wire bonded.

There is a need for a method that is, not exclusively but also, suitable for bonding a rigid electrically conductive element to a bonding partner sensitive to pressure.

### SUMMARY

One Aspect relates to a method in which an electrically conductive element is bonded to a bonding surface of a bonding partner by: increasing a temperature of a bonding section of the electrically conductive element from an initial temperature to an increased temperature by passing an electric heating current through the bonding section; pressing the bonding section with a pressing force against the bonding surface using a sonotrode and introducing an ultrasonic vibration into the bonding section via the sonotrode such that the increased temperature of the bonding section, the ultrasonic signal in the bonding section and the pressing force are simultaneously present and cause the formation of a tight and direct bond between the bonding section and the bonding surface.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 illustrates different views of a setup for bonding an electrically conductive element to a bonding surface of a bonding partner according to a first example.
Figure 2 illustrates different views of a setup for bonding an electrically conductive element to a bonding surface of a bonding partner according to a second example.
Figure 3 illustrates different views of a setup for bonding an electrically conductive element to a bonding surface of a bonding partner according to a third example.
Figure 4 illustrates different views of a setup for bonding an electrically conductive element to a bonding surface of a bonding partner according to a fourth example.
Figure 5 illustrates an example of a setup for bonding an electrically conductive element to a bonding surface of a bonding partner according to a fifth example.
Figure 6 illustrates an example of a setup for bonding an electrically conductive element to a bonding surface of a bonding partner according to a sixth example.
Figure 7 illustrates an example of a setup for bonding an electrically conductive element to a bonding surface of a bonding partner according to a seventh example.
Figure 8 illustrates a flow chart of an example method for bonding an electrically conductive element to a bonding surface of a bonding partner.

### DETAILED DESCRIPTION

In the following detailed description, reference is made to the accompanying drawings. The drawings show specific examples in which the invention may be practiced. Further, the drawings serve to illustrate certain principles, so that only aspects for understanding these principles are illustrated. It is to be understood that the features and principles described with respect to the various examples may be combined with each other, unless specifically noted otherwise. As well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element".

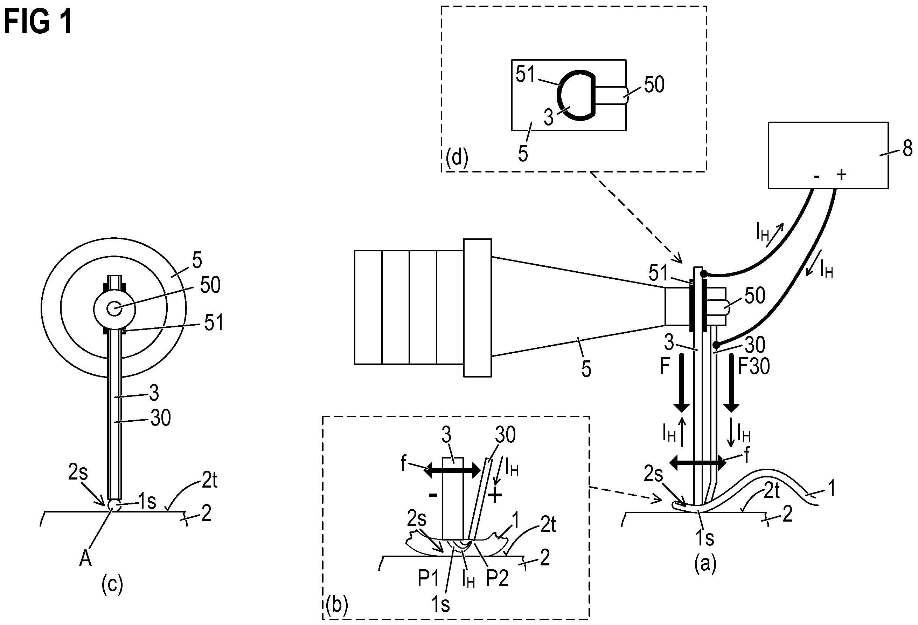

Figure 1 shows different views (a), (b), (c) and (d) of a first example-setup for directly bonding an electrically conductive element 1 to a bonding surface 2t of a bonding partner 2. For the sake of simplicity, the different views (a), (b), (c) and (d) of are also designated as Figures 1(a), 1(b), 1(c) and (1d), respectively. The same applies, analogously, for the other Figures that include different views. In the sense of the present specification, "directly bonding" and its variations is intended to express that the electrically conductive element 1 makes, at the end of the bonding process, physical contact with the bonding surface 2t of the bonding partner 2. Figure 1(a) illustrates a cross-sectional view illustrating how a direct connection between the electrically conductive element 1 and a bonding surface 2t of a bonding partner 2 using an enhanced wire bonding technique may be created. An enlarged section of Figure 1(a) is illustrated in Figure 1(b). The direct connection between the electrically conductive element 1 and the bonding surface 2t, which optionally may be a metallic surface, is formed between a bonding section 1s of the electrically conductive element 1 and a bonding section 2s of the bonding partner 2. That is, at the end of the bonding process, the bonding section Is and the bonding section 2s make physical contact with one another.

Different from conventional wire bonding techniques, the enhanced bonding techniques described herein may employ an electric heating current I_{H} that is passed through the bonding section 1s of the electrically conductive element 1. The electric heating current I_{H}, which is provided by a power supply 8, serves to introduce energy into the bonding section 1s. As a result, the temperature of the bonding section 1s increases from an initial temperature T0 (e.g. room temperature) to an increased temperature T1 (e.g. at least 80 degrees Celsius).

At least in the heated state (i.e. at least at the increased temperature T1), the bonding section 1s is, with a pressing force F, pressed against the bonding surface 2t using the sonotrode 3. The sonotrode 3 is mechanically coupled to an ultrasonic transducer 5. When the sonotrode 3 presses the bonding section 1s against the bonding surface 2t, an ultrasonic signal (i.e. an ultrasonic vibration at an ultrasonic frequency f, e.g. in a range from about 20 kHz to about 120 kHz) is, via the sonotrode 3, transferred from the ultrasonic transducer 5 into the bonding section 1s. Thereby, ultrasonic energy is transferred from the sonotrode 3 to the bonding section Is. The direction of the oscillation of the ultrasonic transducer 5 (indicated by a bold double arrow and reference sign "f" for the ultrasonic frequency) and, accordingly, the direction of the oscillation of the sonotrode 3 may be parallel to a direction the bonding surface 2t has in the region of the bonding section 2s. Introducing the ultrasonic vibration into the bonding section 1s via the sonotrode 3 takes place such that the increased temperature T1 of the bonding section 1s, the ultrasonic signal in the bonding section 1s and the pressing force F affecting the bonding section Is are simultaneously present and cause the formation of a tight and direct bond between the bonding section 1s and the bonding surface 2t. The increased temperature T1 reduces the mechanical stability (e.g. the tensile yield strength, the ultimate tensile strength) of the bonding section Is and, therefore, together with the energy transferred from the ultrasonic vibration and the pressing force F, facilitates the formation of the bonded connection between the bonding section 1s and the bonding surface 2t.

As compared to conventional wire bonding techniques employed in the formation of wire bond connections in electronic circuits, the embodiments described herein may, in addition to the transfer of an ultrasonic vibration and a pressing force F, additionally use an electric heating current I_{H} as described above. The increased temperature T1 caused by the electric heating current I_{H} may allow for bonding a hard (e.g. copper-based) electrically conductive element 1 and/or an electrically conductive element 1 having, as compared to conventional conductive elements, an increased diameter (and/or an increased cross-section) also to pressure-sensitive bonding partners 2.

According to one example, the pressing force F may be greater than a minimum pressing force Fₘᵢₙ and/or less than a maximum pressing force Fₘₐₓ. For instance, the minimum pressing force Fₘᵢₙ may be 1 N (Newton). Alternatively or additionally, the maximum pressing force Fₘₐₓ may be 2500 N (Newton). In principle, however, minimum pressing forces Fₘᵢₙ of less than 1 N and/or maximum pressing forces Fₘₐₓ of more than 2500 N are also possible. If the pressing force F is too low, there is a risk that the (already bonded) electrically conductive element 1 later lifts off from the bonding surface 2t which, of course, is undesired.

According to a further example, as compared to a conventional bonding technique in which an electrically conductive element that is identical to the electrically conductive element 1 is bonded to a bonding surface of a bonding partner that is identical to the bonding partner 2, the employed pressing force F may (but not necessarily needs to) be reduced in view of the increased temperature T1 caused by the heating current I_{H}.

Because the heat dissipation caused by the heating current I_{H} in the bonding section Is increases substantially quadratically with the heating current I_{H}, the increased temperature T1 increases positively with the heating current I_{H}. Therefore, increasing the heating current I_{H} may help to facilitate the formation of the bond connection between the electrically conductive element 1 and the bonding partner 2 so that more rigid electrically conductive elements 1 (e.g. having a large cross-section, being copper-based) may successfully be bonded to the bonding surface 2t. For instance, the heating current I_{H} may be adjusted such that the increased temperature T1 is at least 80°C, e.g. between 80°C and 1200°C.

The ultrasonic bonding process may (e.g. by appropriately adjusting the heating current I_{H}) performed such that the increased temperature T1 remains, during the whole bonding process, below the melting point of the bonding section 1s. Alternatively, the ultrasonic bonding process may (e.g. by appropriately adjusting the heating current I_{H}) be performed such that the increased temperature T1 is greater than or equal to the melting point of the bonding section 1s (such an ultrasonic bonding process may also be referred to as ultrasonic welding process).

The electric heating current I_{H} for heating the bonding section 1s is provided by a power supply 8. As can be seen from Figures 1(a) and 1(b), the electric heating current I_{H} may be supplied to the bonding section 1s using the sonotrode 3 as a first power supply electrode and an additional contact electrode 30 as a second power supply electrode. In order to supply the electric heating current I_{H} to the bonding section 1s, the sonotrode 3 may electrically contact the bonding section Is at a first contacting position P1, and the contact electrode 30 may electrically contact the bonding section 1s at a second contacting position P2 different from the first contacting position P1 (see Figure 1(b)) so that the electric heating current I_{H} may be supplied into the bonding section s1 via the first and second contacting positions P1, P2. Different from the sonotrode 3, the contact electrode 30 is just intended to supply the electric heating current I_{H} to the bonding section Is but not to exert a substantial pressing force onto the bonding section Is as the sonotrode 3 does. For instance, the contact electrode 30 may be pressed against the bonding section Is with a contact force F30 of e.g. less than 20% of the pressing force F exerted by the sonotrode 3. A low contact force F30 may be achieved, e.g., by a spring-like contact electrode 30.

As exemplarily illustrated in Figure 1(a), the contact electrode 30 may be, in addition to the sonotrode 3, mechanically attached to the ultrasonic transducer 5. Naturally, a dielectric isolation 51 is required in order to prevent the ultrasonic transducer 5 from short-circuiting the contact electrode 30 and the sonotrode 3. This can best be seen from Figure 1(a) and the top view of Figure 1(d). In the example of Figure 1(d), the dielectric isolation 51 electrically isolates the sonotrode 3 from the ultrasonic transducer 5. Alternatively or additionally, the (or an additional) dielectric isolation 51 could be used to electrically isolate the contact electrode 30 from the ultrasonic transducer 5. Figure 1(d) also shows that the sonotrode 3 may be mounted to the ultrasonic transducer 5 using a clamping screw 50. The dielectric insulation 51 electrically insulates also the clamping screw 50 from the ultrasonic transducer 5. The contact electrode 30 may be mounted to the ultrasonic transducer 5 in the same or a similar manner as the sonotrode 3.

Figure 1(c) is a schematic illustration showing the arrangement of Figure 1(a) from the front side with a view to the tip of the ultrasonic transducer 5. However, the electrically conductive element 1 is illustrated in cross-section in order to illustrate the cross-sectional area of the bonding section 1s.

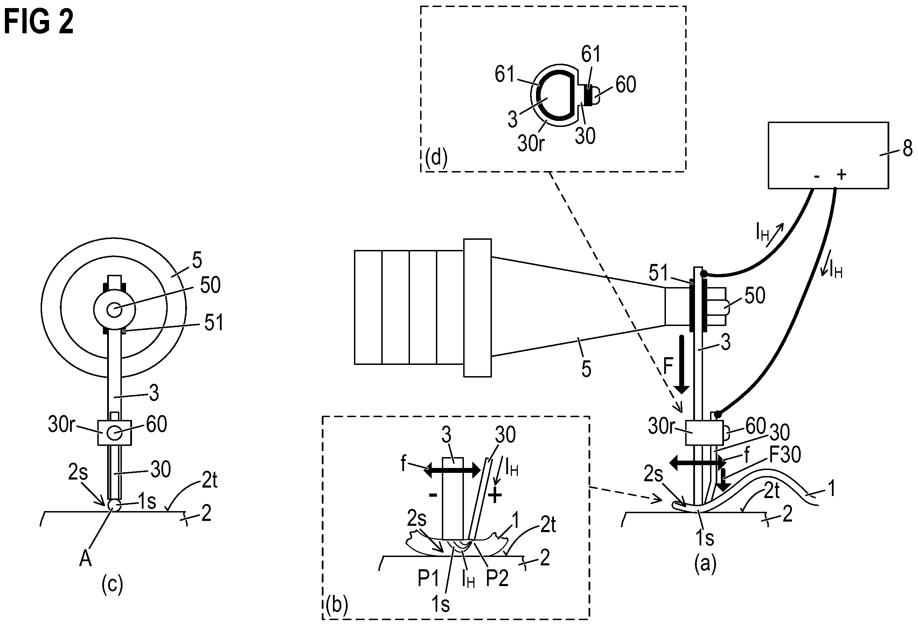

Figure 2 illustrates a modification of the arrangement of Figure 1. In principle, Figures 2(a), 2(b) and 2(c) correspond to Figures 1(a), 1(b) and 1(c), respectively. Apart from the subsequently explained differences, the above description of the example of Figure 1 applies in the same or an analogous manner for the example of Figure 2.

In the example of Figure 1, the contact electrode 30 is mechanically attached to the ultrasonic transducer 5, whereas in the example of Figure 2 the contact electrode 30 is mechanically attached to (but electrically insulated from) the sonotrode 3.

For instance, the sonotrode 3 may be introduced into a ring-shaped section 30r (open or closed ring) of the contact electrode 30, and the contact electrode 30 may be clamped, e.g. using a clamping screw 60, to the sonotrode 3. This can best be seen from Figures 1(a) and 1(d), the latter of which is a horizontal cross-sectional view with the sectional plane running through the ring-shaped portion 30r illustrated in Figure 1(a) and parallel to the bonding surface 2t.

Naturally, a dielectric isolation 61 is required in order to prevent a short-circuit between the contact electrode 30 and the sonotrode 3. This can best be seen from Figure 2(d). In the example of Figure 2(d), the dielectric isolation 61 electrically isolates the contact electrode 30 from the sonotrode 3. Figures 2(a) and 2(d) also show that the sonotrode 3 may be mounted to the sonotrode 3 using a clamping screw 60. The dielectric insulation 61 electrically insulates also the clamping screw 60 from the sonotrode 3.

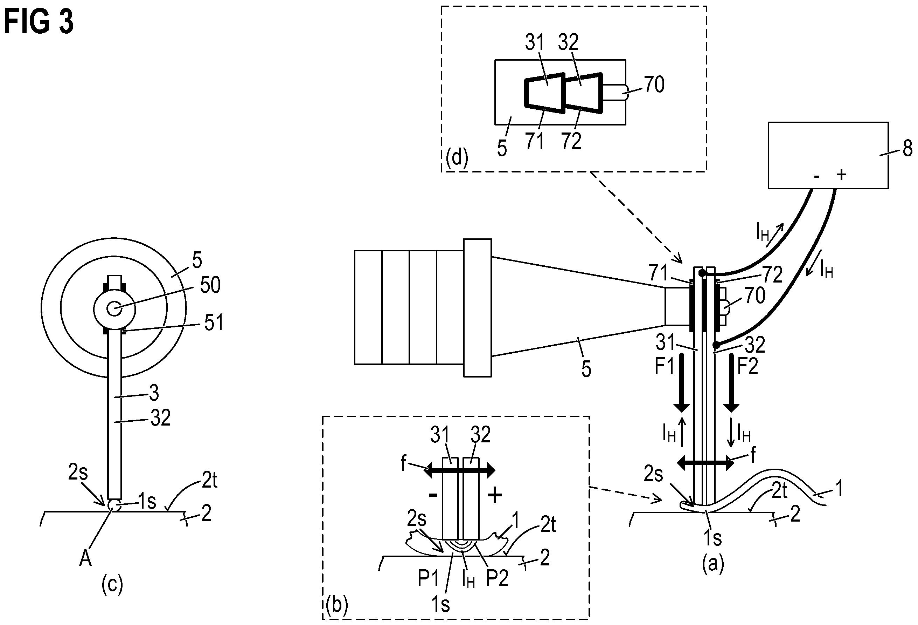

Figure 3 illustrates a modification of the arrangements of Figures 1 and 2. In principle, Figures 3(a), 3(b) and 3(c) correspond to Figures 1(a), 1(b) and 1(c) and 2(a), 2(b) and 2(c), respectively. Apart from the subsequently explained differences, the above description of the examples of Figures 1 and 2 applies in the same or an analogous manner for the example of Figure 3.

In the example of Figure 3, the sonotrode 3 includes a first partial sonotrode 31 and a second partial sonotrode 32. During the bonding process, the bonding section 1s is pressed against the bonding surface 2t with a first pressing force F1 exerted by the first partial sonotrode 31 and with a second pressing force F2 exerted by the second partial sonotrode 32.

As can be seen from Figures 3(a) and 3(b), the electric heating current I_{H} may be supplied to the bonding section 1s using the first partial sonotrode 31 as a first power supply electrode and the second partial sonotrode 32 as a second power supply electrode. In order to supply the electric heating current I_{H} to the bonding section Is, the first partial sonotrode 31 may electrically contact the bonding section 1s at a first contacting position P1, and the second partial electrode 32 may electrically contact the bonding section 1s at a second contacting position P2 different from the first contacting position P1 (see Figure 3(b)) so that the electric heating current I_{H} may be supplied into the bonding section 1s via the first and second contacting positions P1, P2.

Both the first partial sonotrode 31 and the second sonotrode 32 are not only intended to supply the electric heating current I_{H} to the bonding section 1s but also to exert substantial first and second pressing forces F1 and F2, respectively, to the bonding section 1s during the bonding process.

For instance, the first pressing force F1 applied by the first partial sonotrode 31 and the second pressing force F2 simultaneously applied by the second partial sonotrode 32 may be substantially identical. However, there may be a certain difference between the first and second pressing forces F1, F2. For instance, at a certain point of time during the bonding process or at each point of time of the bonding process, the second pressing force F2 may be at least 50% of the first pressing force F1.

As illustrated in Figure 3(a), both the first partial sonotrode 31 and the second partial sonotrode 32 may be mechanically attached to the ultrasonic transducer 5. Naturally, one or more dielectric isolations 71, 72 are required in order to prevent the ultrasonic transducer 5 from short-circuiting the first partial sonotrode 31 and the second partial sonotrode 32. This can best be seen from Figure 3(a) and the cross-sectional view of Figure 3(d). In the example of Figure 3(d), a first dielectric isolation 71 electrically isolates the first partial sonotrode 31 from the ultrasonic transducer 5 and second dielectric isolation 72 electrically isolates the second partial sonotrode 32 from the ultrasonic transducer 5, and at least one of the first dielectric isolation 71 and the second dielectric isolation 72 electrically isolates the first partial sonotrode 31 from the second partial sonotrode 32.

Figures 3(a) and 3(d) also show that the both the first partial sonotrode 31 and the second partial electrode 32 may be mounted to the ultrasonic transducer 5 using a clamping screw 70 clamping both the first partial sonotrode 31 and the second partial electrode 32 to the ultrasonic transducer 5.

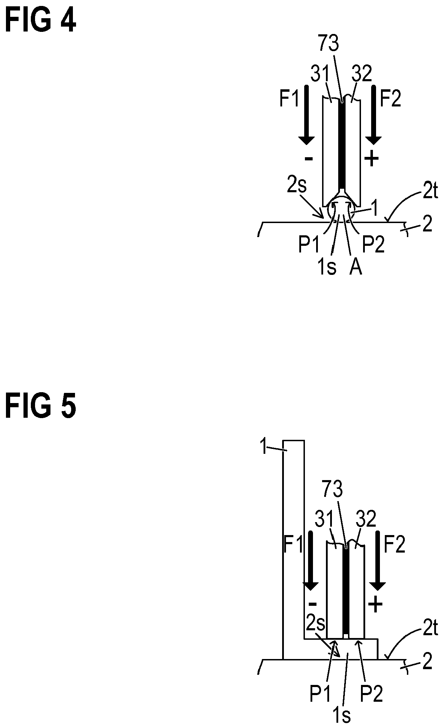

A further option that may be used in connection with using a first partial sonotrode 31 and a second partial electrode 32 is illustrated in Figure 4. As shown, the first partial sonotrode 31 and the second partial electrode 32 may be attached to one another over almost their complete length via a dielectric insulation 73 which extends between and mechanically contacts both the first partial sonotrode 31 and the second partial electrode 32. As illustrated, the dielectric insulation 73 may continuously extend between the first partial sonotrode 31 and the second partial electrode 32 from or from close to the ultrasonic transducer 5 almost as far as the bottom ends of first partial sonotrode 31 and the second partial electrode 32 at which ends the partial sonotrodes 31, 32 make (at respective contacting positions P1 and P2) contact with the bonding section 1s. Thereby, a tight coupling between the first and second partial sonotrodes 31, 32 can be achieved so that the distance between the bottom ends of the first and second partial sonotrodes 31, 32 is well-defined. That is, for a specific type of electrically conductive element 1, the distance between the contacting positions P1 and P2 (which influences the electrical resistance of the bonding section 1s and, therefore, the dissipated heat caused by the heating current I_{H} passing through the bonding section Is) is well defined so that a heating current I_{H} that is appropriate for achieving the desired increased temperature T1 can easily be adjusted and/or pre-selected.

In principle, any electrically conductive element 1 may be bonded to the bonding surface 2t of the bonding partner 2 using the methods described herein. For instance, the electrically conductive element 1 may be a bonding wire having (outside of bonded bonding sections 1s, e.g. in a bonding section Is prior to bonding that bonding section) a substantially circular or a substantially rectangular and constant cross-section. Bonding wires having (outside of bonded bonding sections 1s) a flat, substantially rectangular and constant cross-section are frequently referred to as "ribbons". However, in the sense of the present specification and claims, a "ribbon" is regarded as a special type of bonding wire.

According to an example illustrated in Figure 5, the electrically conductive element 1 may be a (flat or, as illustrated bent) sheet metal. Generally, an electrically conductive element 1 may be used, e.g., as an (internal) electrical interconnection between different electronic parts of an electronic device, or as an (external) electric terminal for electrically connecting an electronic device.

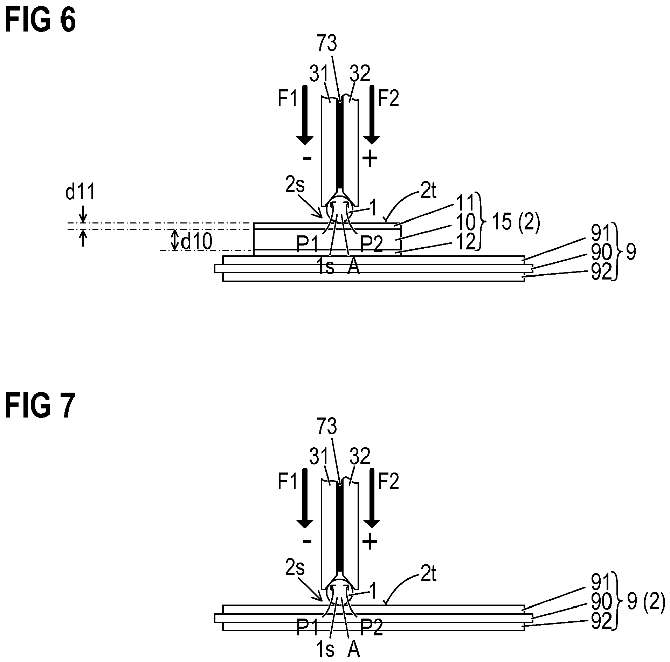

In the examples of Figures 1 to 5, the bonding partner 2 and the bonding surface 2t are illustrated schematically only. Generally, the bonding partner 2 may be any element having a surface 2t, e.g. a metallic surface, to which an electrically conductive element 1 can be bonded. Figures 6 and 7 illustrate examples in which the respective bonding partner 2 includes, at its bonding section 2s underneath the bonding surface 2t, a brittle layer (semiconductor body 10 in Figure 6 and ceramic layer 90 in Figure 7) that may easily crack during a conventional bonding process (i.e. during a bonding process that does not employ a heating current). However, the above-described bonding process taking advantage of the increased temperature T1 (caused in particular by the heating current I_{H}) allows for bonding (not only but also) rigid electrically conductive elements 1 (e.g. electrically conductive elements 1 having bonding sections Is with large cross-sectional areas A and/or comprising copper) to the bonding surface 2t without the occurrence of accidental cracks in the underlying brittle layer 10, 90.

In the example of Figure 6, the bonding partner 2 is a semiconductor chip 15 that includes a semiconductor body 10 (e.g. including an arbitrary semiconductor material like silicon, silicon carbide etc.), a first chip metallization layer 11 and a second chip metallization layer 12. As illustrated, the first and second chip metallization layers 11, 12 may be disposed at opposite sides of the semiconductor body 10. Optionally, the semiconductor chip 1 may be, prior to the bonding process, pre-mounted on a circuit carrier 9 (e.g. using a connecting layer, for instance a solder layer, an adhesive layer or a layer of a sintered metal powder, disposed between and adjoining both the semiconductor chip 1 and the circuit carrier 4). The bonding surface 2t described in the previous examples may be a surface of the first chip metallization layer 11, e.g. the surface of the first chip metallization layer 11 facing away from the semiconductor body 10.

The semiconductor chip 15 (e.g. a diode, a transistor, or any other semiconductor component) may exhibit a certain voltage blocking capability between the first and second chip metallization layers 11, 12. For a particular material of the semiconductor body 10, the voltage blocking capability depends on the thickness d10 (to be measured perpendicularly to the bonding surface 2t) of the semiconductor body 10. That is, for a low voltage blocking capability a small thickness d10 of the semiconductor body 10 is sufficient but makes the semiconductor body 10 sensitive to high pressing forces. The described methods taking advantage of a heating current I_{H} allow for reducing the risk of cracks in particular when bonding a "rigid" electrically conductive element to a semiconductor chip 15 having a small thickness d10.

Some conventional bonding methods in which a "rigid" electrically conductive element 1 is bonded to a first chip metallization layer 11 employ a first chip metallization layer 11 having a large thickness d11 in order to protect the underlying brittle semiconductor body 10 from cracks that may occur during the bonding process. On the one hand, however, an increased thickness d11 increases also the costs involved. On the other hand, an increased thickness d11 of the first chip metallization layer 11 is only suitable for semiconductor chips 15 having a thick semiconductor body 10 because the first chip metallization layer 11 is formed on the semiconductor body 10 when the latter is still part of a (not yet singulated) semiconductor wafer having a large diameter. However, such a thin semiconductor wafer with a thick metallization layer (a part of which will, after the singulation of the wafer, form the first chip metallization layer 11) disposed on it will show a significant bending ("wafer bow") when the temperature changes. Therefore, a thin semiconductor wafer with a thick metallization layer disposed on it cannot be properly processed in conventional wafer fabs because of the wafer bow.

Therefore, the conventional bonding methods bonding a "rigid" electrically conductive element 1 to a first chip metallization layer 11 employ a first chip metallization layer 11 having a large thickness d11 only for semiconductor chips 15 having a comparatively thick semiconductor body 10. However, the presently described aspect of a bonding method in which an increased temperature T1 of a bonding section 1s is generated by electrically heating the bonding section 1s allows also for bonding a "rigid" electrically conductive element 1 to a thin first chip metallization layer 11 formed on a thin semiconductor body 10.

According to a further example illustrated in Figure 7, the bonding partner 2 may be a circuit carrier 9 (also referred to as "substrate") that includes a brittle ceramic layer 90, a first substrate metallization layer 91 and an optional second substrate metallization layer 92. As illustrated, the first and second substrate metallization layers 91, 92 may be disposed at opposite sides of the ceramic layer 90. The layer thickness of the first substrate metallization layer 91 may be, e.g., in a range from 2 µm (micrometers) to 30 µm.

Each of the first and, if provided, second substrate metallization layers 91, 92 may consist of or include, without being restricted to, one of the following materials: copper; a copper alloy; aluminum; an aluminum alloy; any other metal or alloy that remains solid during the operation of the semiconductor assembly. According to one example, the ceramic may, without being restricted to, consist of or include one of the following materials: aluminum oxide; aluminum nitride; zirconium oxide; silicon nitride; boron nitride; any other dielectric ceramic. For instance, the circuit board 2 may be, e.g., a Direct Copper Bonding (DCB) substrate, a Direct Aluminum Bonding (DAB) substrate, or an Active Metal Brazing (AMB) substrate. However, the circuit carrier 9 may also be a conventional printed circuit board (PCB) having a non-ceramic dielectric insulation layer 90. For instance, a non-ceramic dielectric insulation layer may consist of or include a cured resin.

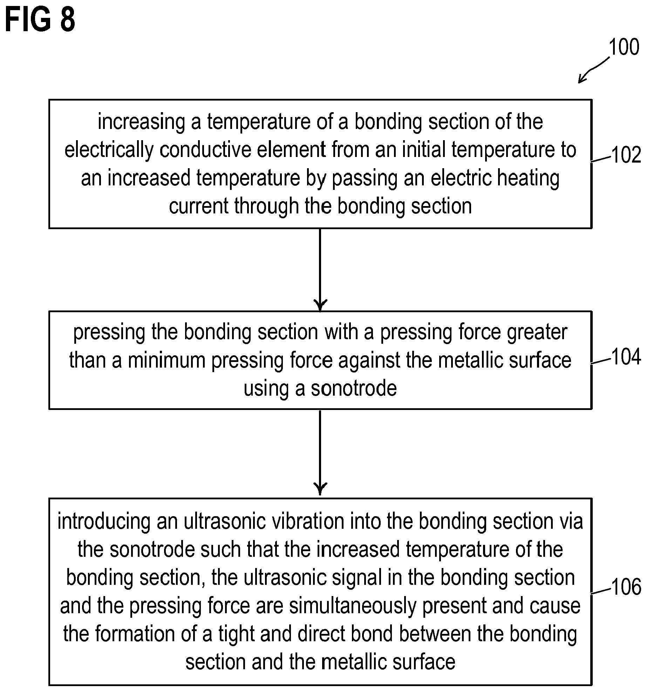

Figure 8 illustrates a flow chart of an example method 100 for bonding an electrically conductive element to a bonding surface of a bonding partner. In a step 102, a temperature of a bonding section 1s of an electrically conductive element 1 is increased from an initial temperature T0 an increased temperature T1 by passing an electric heating current I_{H} through the bonding section 1s. According to step 104, the bonding section 1s is pressed against the bonding surface 2t with a pressing force F greater than a minimum pressing Fₘᵢₙ force using a sonotrode 3 (31, 32). According to step 106, an ultrasonic vibration is introduced into the bonding section 1s via the sonotrode 3 (31, 32) such that the increased temperature T1 of the bonding section 1s, the ultrasonic signal in the bonding section 1s and the pressing force F are simultaneously present and cause the formation of a tight and direct bond between the bonding section 1s and the bonding surface 2t.

Prior to supplying the electric heating current I_{H} to the bonding section Is, the sonotrode 3 (or 31, 32) may optionally be pressed against the bonding section Is and activated (i.e. vibrated at an ultrasonic frequency) in order to locally remove a dielectric surface layer (e.g. an oxide layer) of the bonding section 1s so as to allow for a better electrical contact between the sonotrode 3 (or 31, 32) and the bonding section 1s. That is, the pressing force F may be applied to the bonding section Is prior to and/or during the electric heating current I_{H}. However, in other embodiments, the electric heating current I_{H} may be applied to the bonding section 1s prior to and/or during the pressing force F.

Dimensions of an electrically conductive element 1 may be, at the bonding section Is of the electrically conductive element 1, a cross-sectional area A that is circular having a diameter in a range from 125 µm (micrometers), or substantially rectangular area having a length in a range from 400 µm to 6000 µm, and a height in a range from 30 µm to 2000 µm. For instance, the cross-sectional area A may be at least 0.3 mm² (this is approximately the cross-section of an electrically conductive element wire having a diameter of 125 µm). In principle, however, any other cross-sectional area A and/or geometry may also be used.

According to a further option, the bonding process may take place in an inert or reducing atmosphere (e.g. Ar, SF₆, H₂) in order to prevent a surface oxidation of the electrically conductive element 1 and the bonding surface 2t caused by the increased temperature T1.

## Claims

1. A method for bonding an electrically conductive element to a bonding surface of a bonding partner, the method comprising:
increasing a temperature of a bonding section of the electrically conductive element from an initial temperature to an increased temperature by passing an electric heating current through the bonding section;
pressing the bonding section with a pressing force against the bonding surface using a sonotrode and introducing an ultrasonic vibration into the bonding section via the sonotrode such that the increased temperature of the bonding section, the ultrasonic signal in the bonding section and the pressing force are simultaneously present and cause the formation of a tight and direct bond between the bonding section and the bonding surface.

2. The method as claimed in claim 1, wherein the increased temperature is one of:
greater than 80°C and less than a melting point of the bonding section; or
greater than 80°C and greater than or equal to a melting point of the bonding section.

3. The method as claimed in claim 1 or 2, wherein the electric heating current is supplied to the bonding section via the sonotrode.

4. The method as claimed in any of the preceding claims, wherein:
the sonotrode comprises a first partial sonotrode and a second partial sonotrode;
pressing the bonding section with the pressing force against the bonding surface comprises: pressing the bonding section with a first pressing force against the bonding surface using the first partial sonotrode and pressing the bonding section with a second pressing force against the bonding surface using the second partial sonotrode, the second force being at least 50% of the first pressing force; and
the electric heating current is supplied to the bonding section via both the first partial sonotrode and the second partial sonotrode.

5. The method as claimed in claim 4, wherein passing the electric heating current through the bonding section comprises:
electrically contacting the bonding section by the first partial sonotrode at a first contacting position; and
electrically contacting the bonding section by the second partial sonotrode at a second contacting position.

6. The method as claimed in one of claims 1 to 3 comprising:
pressing a contact electrode against the bonding section with a contact force of less than 20% of the pressing force;
wherein the electric heating current is supplied to the bonding section via both the sonotrode and the contact electrode.

7. The method as claimed in claim 6, wherein passing the electric heating current through the bonding section comprises:
electrically contacting the bonding section by the sonotrode at a first contacting position; and
electrically contacting the bonding section by the contact electrode at a second contacting position;

8. The method as claimed in any of the preceding claims, wherein:
the bonding partner is a semiconductor chip; and
the bonding surface is a surface of a metallization layer of the semiconductor chip.

9. The method as claimed in claim 8, wherein the metallization layer of the semiconductor chip is a copper layer comprising a layer thickness of less than or equal to 20 µm.

10. The method as claimed in any of claims 1 to 7, wherein:
the bonding partner is a circuit carrier comprising a ceramic layer; and
the bonding surface is a surface of a metallization layer of the circuit carrier.

11. The method as claimed in one of the preceding claims, wherein the electrically conductive element is one of:
a bonding wire;
a bonding ribbon;
a sheet metal.

12. The method as claimed in one of the preceding claims, wherein the electrically conductive element comprises, in the bonding section, a cross-sectional area of at least 0.3 mm².

13. The method as claimed in one of the preceding claims, wherein the pressing force is greater than a minimum pressing force of 1 N.

14. The method as claimed in one of the preceding claims, wherein the pressing force is less than a maximum pressing force of 2500 N.
